# EUROPÄISCHE PATENTSCHRIFT

(11) **EP 2 438 833 B1**
(45) Veröffentlichungstag und Bekanntmachung des Hinweises auf die Patenterteilung: **21.11.2012**
(21) Anmeldenummer: 11010034.4
(22) Anmeldetag: 20.12.2006
(51) Int. Cl.: A47B 88/04, H02K 5/24, H02K 5/22

(54) **Antriebseinheit für bewegbare Möbelteile**
Drive unit for mobile pieces of furniture
Unité d'entraînement pour éléments de meuble mobiles

(30) Priorität: 13.02.2006 AT 2212006
(43) Veröffentlichungstag der Anmeldung: 11.04.2012
(62) Teilanmeldung aus: 06827958.7
(73) Patentinhaber: Julius Blum GmbH, 6973 Höchst (AT)
(72) Erfinder: Huber, Edgar, 6971 Hard (AT)
(74) Vertreter: Gangl, Markus

(56) Entgegenhaltungen:
- EP-A1- 0 591 665
- WO-A-2004/095675
- WO-A-2004/100718
- DE-U1- 9 418 283
- FR-A- 2 864 717

## Beschreibung

Die vorliegende Erfindung betrifft eine Antriebseinheit für ein in bzw. an einem Möbelkorpus bewegbar gelagertes Möbelteil, mit einem Gehäuse, in bzw. an dem ein Elektromotor und eine Schnittstelle zur Kontaktierung elektrischer Leitungen angeordnet sind, wobei der Elektromotor in einem ersten Teil des Gehäuses angeordnet ist.

Der Betrieb derartiger Antriebseinheiten ist häufig mit einer von den Benutzem als störend verbundenen Lärmentwicklung verbunden. Durch das Umhüllen der Antriebseinheit mit schalldämpfendem Material oder dem Vorsehen eines Bereichs aus schalldämpfendem Material zwischen der Antriebseinheit und dem Möbelkorpus kann die Entstehung von Körperschall durch die Schallweiterleitung von der Antriebseinheit auf den Möbelkorpus reduziert werden. Möbel mit derartig gedämpften Antriebseinheiten gehen beispielsweise aus der JP 2002-253366 A, JP 2004-073622 A und der WO 2002/062184 A2 hervor.

Antriebseinheiten mit einem Gehäuse, in bzw. an dem ein Elektromotor und elektrische Leitungen angeordnet sind, gehen beispielsweise aus den folgenden Druckschriften hervor: WO 2004 100632 A1, EP 0 591 665 A1, WO 2005 036715 A1, EP 0 926 803 A2, AT 1 379 2004.

Die WO 2004 100632 A1 betrifft eine derartige Antriebseinheit für ein in einem Möbel bewegbar gelagertes Möbelteil sowie Vorkehrungen zur Dämpfung von Vibrationen und Lärm durch schalldämpfendes Material. Die EP 0 591 665 A1 beschreibt eine Antriebseinheit mit zweiteiligem Gehäuse, wobei der Elektromotor in einem ersten Teil des Gehäuses und eine Schnittstelle zur Kontaktierung elektrischer Leitungen an einem zweiten Teil des Gehäuses angeordnet sind und ein Bereich aus schalldämpfendem Material vorgesehen ist. Die WO 2005 036715 A1 betrifft die Kontaktierung elektrischer Leitungen an einem Elektromotor (Gebläsemotor) und Maßnahmen zur Schalldämpfung (durch Verzicht auf eine Schnittstelle am Gehäuse). Die EP 0 926 803 A2 befasst sich mit Vorkehrungen zur Dämpfung von Vibrationen eines Elektromotors (Gebläse) durch begrenzt gegeneinander bewegbar gelagerte Gehäuseteile. Die AT 13792004 A hat eine Antriebseinheit mit einem durch den Elektromotor antreibbaren Ausstoßhebel zum Gegenstand.

Die Lagerung einer Antriebseinheit an einem Möbelkorpus mittels Bereichen aus schalldämpfendem Material ist insofern problematisch als die Antriebseinheit bei dieser Form der Lagerung durch im Betrieb hervorgerufene Vibrationen in ihrer Funktion beeinträchtigt werden kann. Beispielsweise kann es zu einem des Kontaktes zwischen Schnittstelle und elektrischer Leitungen und damit zu einer Unterbrechung der Stromversorgung des Elektromotors kommen. Besonders massiv tritt dieses Problem auf, wenn die Antriebseinheit nur über Bereiche aus schalldämpfendem Material mit dem Möbel verbunden ist.

Zur Behebung dieses Problems ist man daher beim Stand der Technik dazu gezwungen, die Maßnahmen zur Schalldämpfung in einem geringeren Maße anzuwenden, als dies an sich erwünscht wäre.

Aufgabe der Erfindung ist es, eine Antriebseinheit bereitzustellen, welche dazu geeignet ist, trotz Schalldämpfung ohne Beeinträchtigung Ihrer Funktionen betrieben zu werden.

Diese Aufgabe wird durch eine Antriebseinheit mit den Merkmalen des Anspruchs 1 gelöst.

Durch die zweiteilige Ausführung des Gehäuses der Antriebseinheit kann einerselts eine hinreichend feste Verbindung der Schnittstelle mit den von ihr zu kontaktierenden elektrischen Leitungen sichergestellt werden, da der zweite Teil des Gehäuses, welche die Schnittstelle aufweist, beliebig fest mit dem Möbelkorpus bzw, gegebenenfalls an einem am Möbelkorpus befestigten Trägerelement verbunden werden kann. Andererseits kann der erste Teil des Gehäuses mit Bereichen aus schalldämpfendem Material versehen werden, ohne dass es durch mögliche Vibrationen des ersten Teils des Gehäuses zu einem Lösen der Schnittstelle kommt.

Eine nicht durch Ansprüche umfasste einfache Bauweise ergibt sich, wenn vorgesehen ist, dass der zweite Teil des Gehäuses mit dem ersten Teil des Gehäuses, vorzugsweise ausschließlich, durch einen flexiblen Abschnitt verbunden ist. Durch diese Maßnahme kann nämlich einerseits erreicht werden, dass elektrische Leitungen, welche von der Schnittstelle wenigstens zum Elektromotor führen im bzw. am flexiblen Abschnitt angeordnet sind. Es kann daher auf besondere weitere Verbindungen zwischen dem ersten Teil des Gehäuses und dem zweiten Teil des Gehäuses, wie beispielsweise zwischen den beiden Gehäuseteilen verlaufende Stromkabel, verzichtet werden.

Andererseits stellt ein flexibler Abschnitt eine sehr kostengünstige Möglichkeit der Verbindung des ersten und des zweiten Teils des Gehäuses dar, bei der eine gewisse begrenzte Bewegbarkeit der beiden Gehäuseteile untereinander gegeben ist. Erfindungsgemäß ist ein Drehgelenk vorgesehen.

Die erfindungsgemäße Antriebseinheit ist besonders vorteilhaft, wenn vorgesehen ist, dass die Schnittstelle Piercingstifte aus elektrisch leitfähigem Material aufweist. Eine derart ausgebildete Antriebseinheit lässt sich besonders leicht für die Inbetriebnahme montieren, da durch das Eindringen der Piercingstifte in entsprechend am Möbelkorpus bzw. gegebenenfalls an einem Trägerelement angeordnete elektrische Leitungen in einem Handgriff bei der Montage die elektrische Versorgung der Antriebseinheit sichergestellt wird. Durch die zweiteilige Ausführung des Gehäuses ist andererseits sichergestellt, dass es zu keiner Verbiegung der einzelnen Piercingstifte, hervorgerufen durch Vibrationen von im ersten Teils des Gehäuses angeordneten Komponenten (Elektromotor, Getriebe, Ausstoßhebel und dergleichen) kommen kann.

Grundsätzlich kann die Antriebseinheit mit dem anzutreibenden bewegbaren Möbelteil, bei welchem es sich beispielsweise um eine Schublade oder um eine Möbeltüre handelt, über verschiedenste Mittel zur Kraftübertragung zusammenwirken. Ist beispielsweise vorgesehen, dass die Antriebseinheit über den gesamten Öffnungs- bzw. Schließweg des bewegbaren Möbelteils Kräfte auf dieses ausüben soll, muss die Antriebseinheit über den gesamten Öffnungs- bzw. Schließweg mit dem bewegbaren Möbelteil gekoppelt sein. Hierfür bietet sich beispielsweise als Kraftübertragungsmittel ein Zugmittel, insbesondere ein Zahnriemen oder ein Seil, an.

Besonders bevorzugt ist jedoch eine Ausführungsform der Erfindung, bei welcher vorgesehen ist, dass am ersten Teil des Gehäuses ein durch den Elektromotor antreibbarer Ausstoßhebel angeordnet ist. In diesem Fall ist die Antriebseinheit als reine Ausstoßvorrichtung ausgebildet, welche dazu dient, das bewegbare Möbelteil aus dessen geschlossener Endlage in bzw. am Möbelkorpus wenigstens derart weit auszustoßen, dass ein Benutzer händisch die vollständige Öffnung des bewegbaren Möbelteils bewirken kann.

In besonderem Einklang mit dem Erfindungsgedanken steht eine Ausführungsform bei welcher vorgesehen ist, dass alle im Betrieb der Antriebseinheit Lärm erzeugende Komponenten (wie zum Beispiel Elektromotor, Getriebe oder Ausstoßhebel) der Antriebseinheit ausschließlich im ersten Teil des Gehäuses angeordnet sind.

Um die Übertragung von Vibrationen vom ersten Teil des Gehäuses auf den zweiten Teil des Gehäuses zu vermeiden, kann bei allen oben genannten Ausführungsformen vorgesehen sein, dass zwischen dem ersten und dem zweiten Teil des Gehäuses wenigstens ein Bereich aus schalldämpfendem Material angeordnet ist. Als schalldämpfendes Material kann beispielsweise ein offen- oder geschlossenzelliger Stoff, beispielsweise ein Polyurethan-Elastomer, oder ein Kautschuk-, Silikon-, EVA-oder PE-Schaum verwendet werden.

Bei einer besonders bevorzugten, sehr leicht montierbaren Ausführungsform der Erfindung ist vorgesehen, dass am zweiten Teil des Gehäuses eine durch einen Klemmhebel bedienbare Spannzange und am ersten Teil des Gehäuses eine Nase angeordnet ist. Wobei die Antriebseinheit über die Nase und die Spannzange an einem Trägerelement befestigbar ist.

Die Erfindung betrifft auch ein Möbel mit einem Möbelkorpus und insbesondere einem am Möbelkorpus befestigten Trägerelement, wobei entweder am Möbelkorpus oder gegebenenfalls am Trägerelement eine Antriebseinheit nach einer der vorstehend beschriebenen Ausführungsformen befestigt ist.

Hierbei kann zur Erzielung einer maximalen Schalldämpfung vorgesehen sein, dass der erste Teil des Gehäuses der Antriebseinheit den Möbelkorpus bzw. gegebenenfalls das Trägerelement nur über Bereiche aus schalldämpfendem Material berührt.

Um Probleme mit der elektrischen Kontaktierung zu vermeiden, kann vorgesehen sein, dass die Schnittstelle elektrische Leitungen, welche am Möbelkorpus bzw. gegebenenfalls am Trägerelement angeordnet sind, im Wesentlichen spielfrei kontaktiert.

Weitere Vorteile und Einzelheiten der Erfindung ergeben sich anhand der nachstehenden Figuren sowie der dazugehörigen Figurenbeschreibung. Dabei zeigen:
- Fig. 1: eine Draufsicht auf ein Ausführungsbeispiel einer erfindungsgemäßen Antriebseinheit.
- Fig. 2a, 2b: eine perspektivische Ansicht der in Fig. 1 dargestellten Antriebseinheit sowie eine dazugehörige Detailansicht,
- Fig. 3a, 3b: eine perspektivische Ansicht bzw. eine Draufsicht auf die in den vorstehenden Figuren gezeigte Ausstoßvorrichtung vor bzw. bei der Montage an einem Trägerelement,
- Fig. 4: in Draufsicht die in den Fig. 3a und 3b dargestellte Antriebseinheit im montierten Zustand an einem Trägerelement,
- Fig. 5a, 5b: die in Fig. 4 montierten Zustand dargestellte Antriebseinheit in perspektivischer Ansicht sowie in einer dazugehörigen Detailansicht und
- Fig. 6a, 6b: ein Möbel mit einer erfindungsgemäßen Ausstoßvorrichtung im montierten Zustand an einem Trägerelement in perspektivischer Ansicht bzw. in Draufsicht.

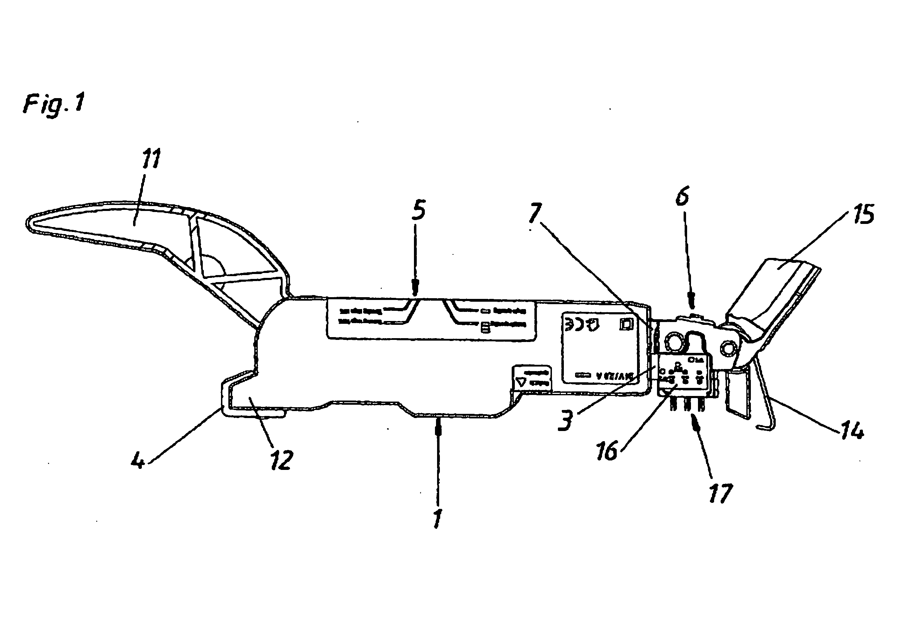

Fig. 1 zeigt eine Antriebseinheit 1 für ein nicht dargestelltes bewegbares Möbelteil, wobei die Antriebseinheit 1 in diesem Ausführungsbeispiel als Ausstoßvorrichtung ausgebildet ist und das bewegbare Möbelteil über den Ausstoßhebel 11 aus einer geschlossenen Endlage im Möbelkorpus ausstoßen kann. Das Gehäuse der Antriebseinheit 1 weist einen ersten Teil 5 und einen zweiten Teil 6 auf, welche über einen flexiblen Abschnitt 7 miteinander verbunden sind. Zwischen dem ersten Teil 5 und dem zweiten Teil 6 des Gehäuses ist ein Bereich 3 aus schalldämpfendem Material angeordnet. Ebenso ist am ersten Teil 5 des Gehäuses im Bereich der Nase 12 ein weiterer Bereich 4 aus schalldämpfenden Material angeordnet. Der Elektromotor dessen Steuer- bzw. Regeleinheit sowie ein Getriebe zur Kraftübertragung vom Elektromotor auf den Ausstoßhebel 11 sind allesamt im ersten Teil des Gehäuses 5 angeordnet (in Fig. 1 nicht dargestellt, weil zum Stand der Technik gehörend).

Im zweiten Teil 6 des Gehäuses der Antriebseinheit 1 ist eine Schnittstelle 16 angeordnet, wobei elektrische Leitungen von der Schnittstelle 16 über den flexiblen Abschnitt 7 in das erste Teil 5 des Gehäuses führen und dort alle Komponenten versorgen, welche elektrischen Strom benötigen. Die Schnittstelle 16 weist in diesem Ausführungsbeispiel drei Dreiergruppen von Piercingstiften 17 auf, welche zur Kontaktierung von in Fig. 1 nicht dargestellten Stromleitungen, die mit dem Stromnetz in Verbindung stehen, ausgebildet sind. An sich ist die Schnittstelle 16 von einem Gehäuseteil bedeckt, welcher allerdings in Fig. 1 nicht dargestellt ist.

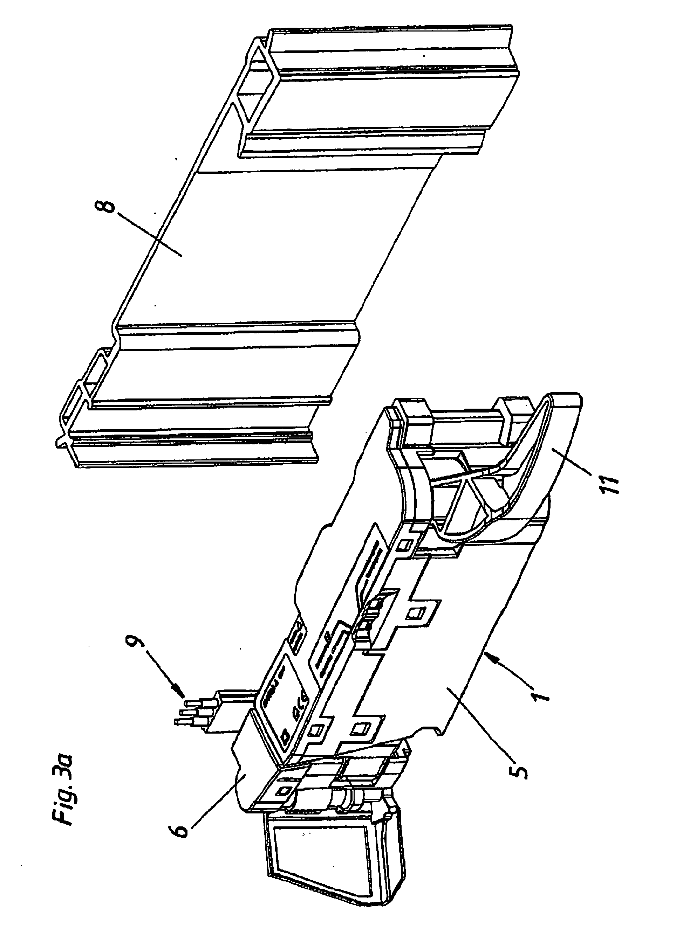

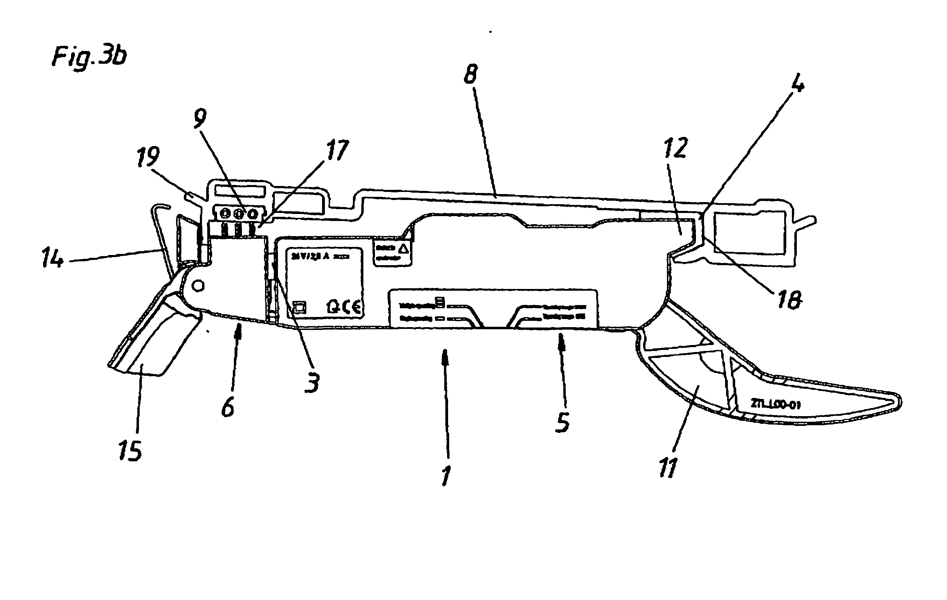

Erkennbar ist in Fig. 1 weiters eine durch einen Klemmhebel 15 bedienbare Spannzange 14, welche zur Befestigung der Antriebseinheit 1 dient (siehe die nachstehende Beschreibung zu den Fig. 3 bis 5).

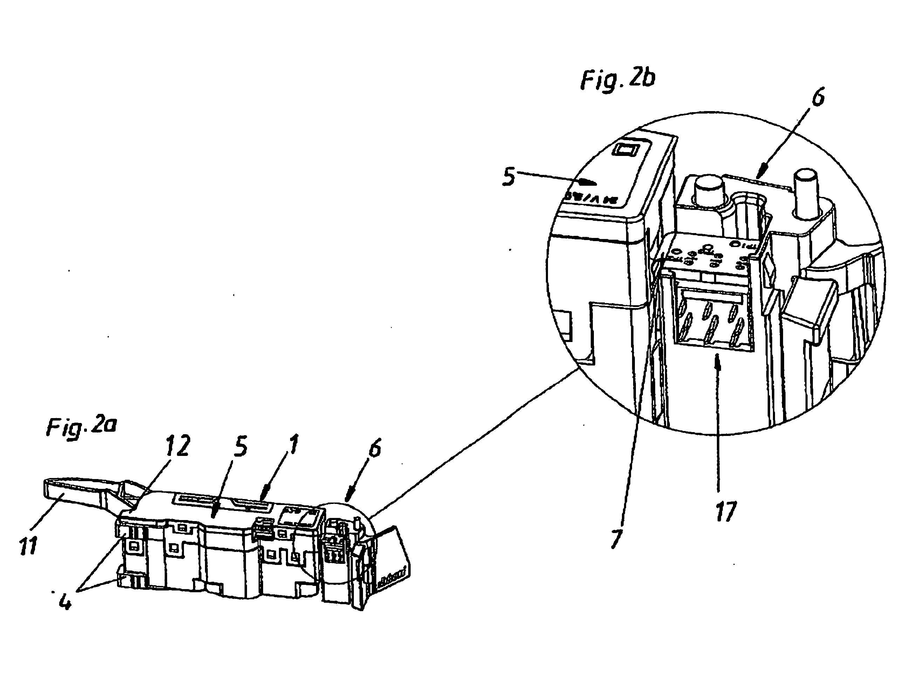

In Fig. 2a ist erkennbar, dass im Bereich der Nase 12 zwei Bereiche 4 aus schalldämpfendem Material angeordnet sind. Aus Fig. 2b ist insbesondere die Ausbildung der Schnittstelle 16 sowie die von der Schnittstelle 16 zum ersten Teil 5 des Gehäuses führende Verbindung 7 erkennbar.

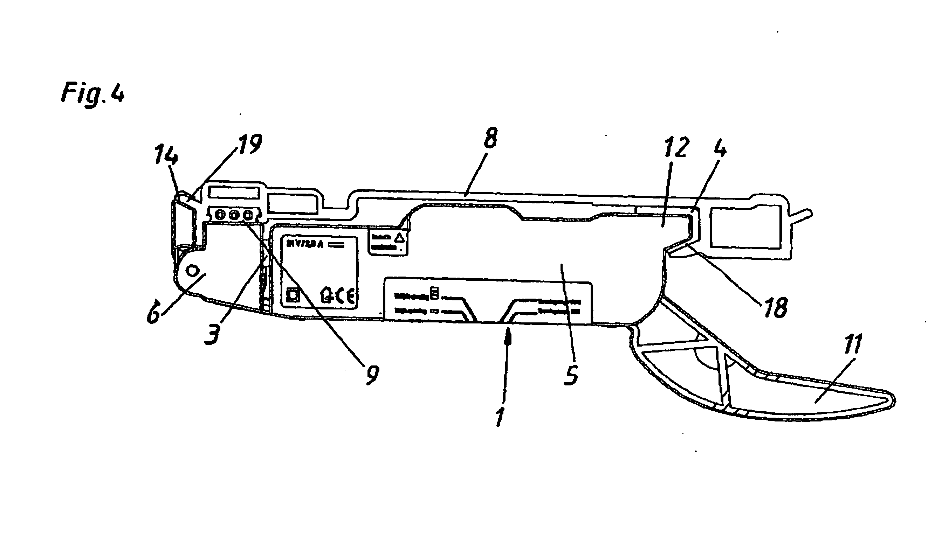

Fig. 3a zeigt eine erfindungsgemäße Antriebseinheit 1 vor der Montage an einem Trägerelement 8, welches seinerseits an einem in den Fig. 3a und 3b nicht dargestellten Möbelkorpus befestigt ist. Insbesondere aus Fig. 3b geht hervor, dass der erste Teil 5 des Gehäuses nur über Bereiche 4 aus schalldämpfendem Material mit dem Trägerelement 8 verbunden ist. Zur Montage der Antriebseinheit 1 wird der erste Teil 5 des Gehäuses mit der Nase 12 in eine entsprechende Ausnehmung 18 des Trägerelementes 8 eingehängt. Anschließend wird die Antriebseinheit 1 um die durch die Nase 12 vorgegebene Schwenkachse in Richtung des Trägerelements 8 verschwenkt, bis der zweite Teil 6 des Gehäuses mit seinem Piercingstiften 17 am Trägerelement 8 derart zur Anlage kommt, dass sich die Piercingstifte 17 in unmittelbarer Nähe zu am Trägerelement 8 vertikal verlaufenden Strom- bzw. Datenleitungen 9 befinden. Die Spannzange 14 wird hinter die Kante 19 des Trägerelements 8 geführt und durch ein Anziehen des Bedienhebels 15 verrastet. Fig. 4 zeigt die Antriebseinheit 1 in montiertem Zustand am Trägerelement 8, wobei in Fig. 4 die Piercingstifte 17, welche die elektrischen Leitungen 9 kontaktieren, nicht dargestellt sind.

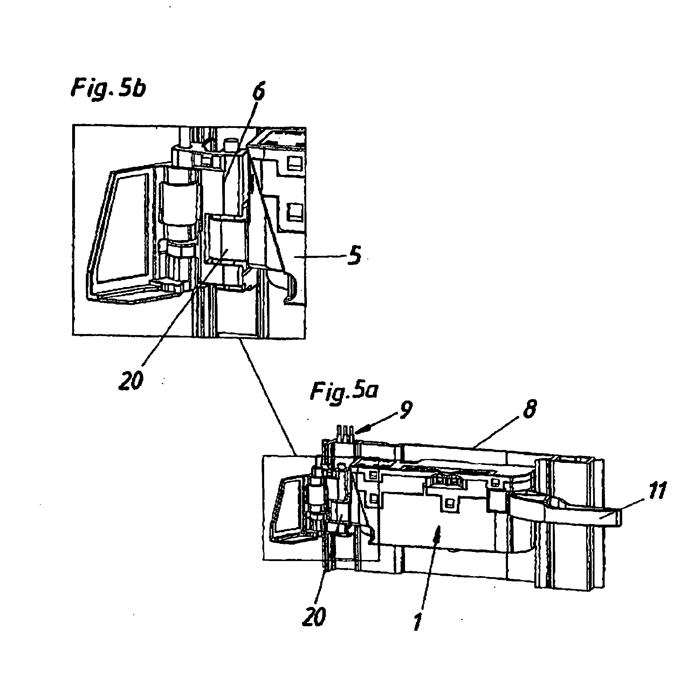

Aus den Fig. 5a und 5b geht in einer perspektivischen Ansicht bzw, einer Detailansicht die Anordnung der Antriebseinheit 1 am Trägerelement 8 hervor. Erkennbar ist auch, dass in diesem Ausführungsbeispiel der erste Teil 5 und der zweite Teil 6 des Gehäuses über ein Drehgelenk 20 miteinander verbunden sind.

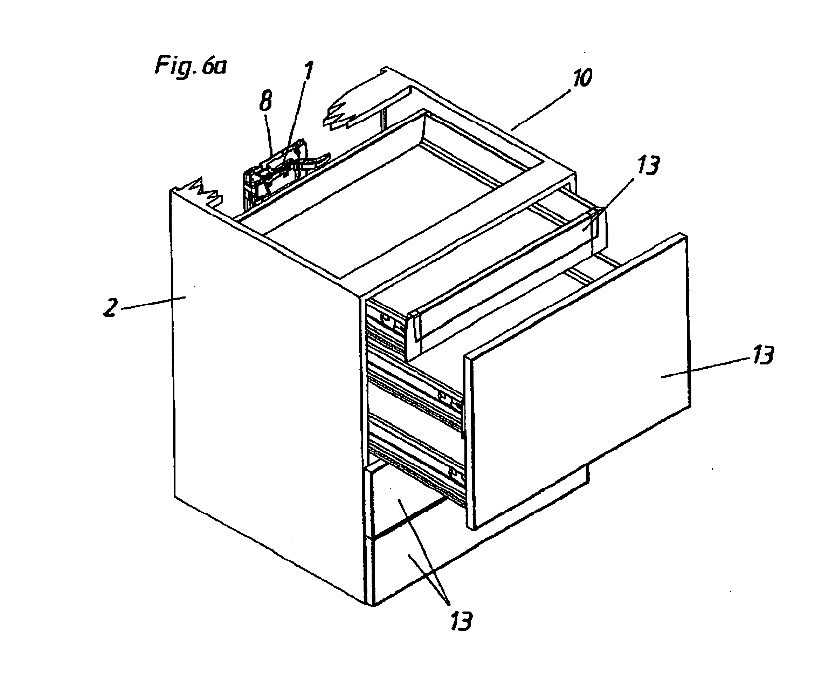

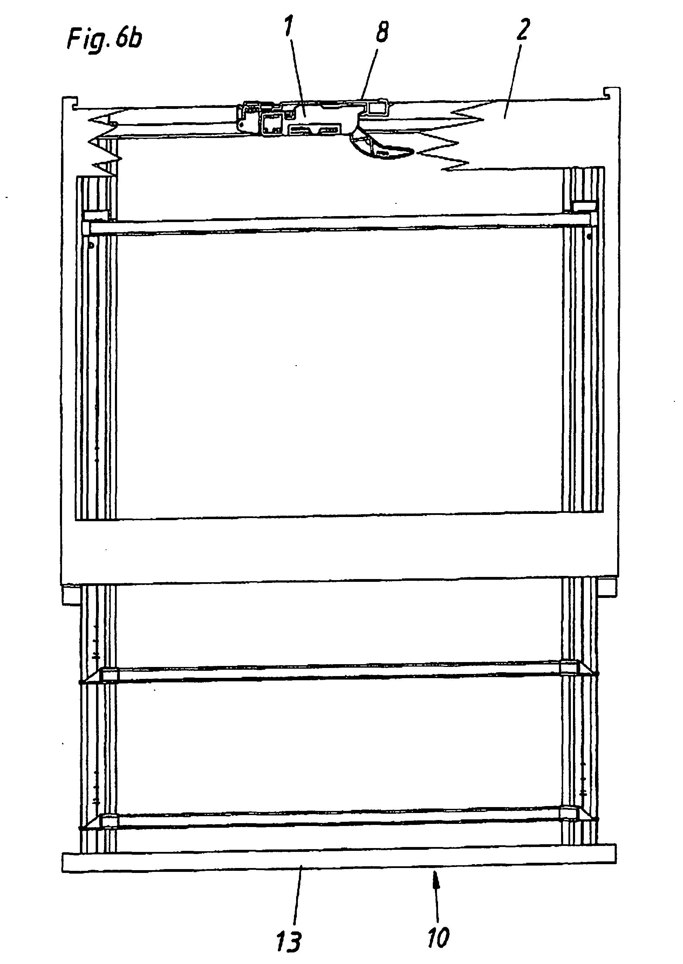

In den Fig. 6a und 6b ist ein Möbel 10 dargestellt, welches einen Möbelkorpus 2 aufweist, in dem Schubladen 13 bewegbar gelagert sind. Jede Schublade 13 ist dabei einer erfindungsgemäßen Antriebseinheit 1 zugeordnet, welche an einem Trägerelement 8 befestigt ist, das seinerseits an der Rückwand des Möbelkorpus 2 angeordnet ist. In Fig. 6b ist der besseren Erkennbarkeit halber die Deckplatte des Möbels 10 entfernt.

## Patentansprüche

1. Antriebseinheit (1) für ein in bzw. an einem Möbelkorpus (2) bewegbar gelagertes Möbelteil (13), mit einem Gehäuse, in bzw. an dem ein Elektromotor und eine Schnittstelle (16) zur Kontaktierung elektrischer Leitungen angeordnet sind, wobei der Elektromotor in einem ersten Teil (5) des Gehäuses angeordnet ist, wobei die Schnittstelle (16) in bzw. an einem zweiten Teil (6) des Gehäuses angeordnet ist, der bezüglich des ersten Teiles (5) des Gehäuses begrenzt bewegbar gelagert ist, **dadurch gekennzeichnet, dass** der zweite Teil (6) des Gehäuses mit dem ersten Teil (5) des Gehäuses, vorzugsweise ausschließlich, durch ein Drehgelenk verbunden ist.

2. Antriebseinheit nach Anspruch 1, **dadurch gekennzeichnet, dass** im bzw. am Drehgelenk wie an sich bekannt elektrische Leitungen angeordnet sind, die von der Schnittstelle (16) wenigstens zum Elektromotor führen.

3. Antriebseinheit nach einem der Ansprüche 1 bis 2. **dadurch gekennzeichnet, dass** die Schnittstelle (16) Piercingstifte (17) aus elektrisch leitfähigem Material aufweist.

4. Antriebseinheit nach einem der Ansprüche 1 bis 3, **dadurch gekennzeichnet, dass** am ersten Teil (5) des Gehäuses wie an sich bekannt ein durch den Elektromotor antreibbarer Ausstoßhebel (11) angeordnet ist.

5. Antrishseinheit nach einem der Ansprüche 1 bis 4, **dadurch gekennzeichnet, dass** alle im Betrieb der Antriebseinheit (1) Lärm erzeugenden Komponenten der Antriebseinheit (1) ausschließlich im ersten Teil (5) des Gehäuses angeordnet sind.

6. Antriebseinheit nach einem der Ansprüche 1 bis 5, **dadurch gekennzeichnet, dass** zwischen dem ersten und dem zweiten Teil (5, 6) des Gehäuses wie an sich bekannt wenigstens ein Bereich (3) aus schalldämpfendem Material angeordnet ist.

7. Antriebseinheit nach Anspruch 6, **dadurch gekennzeichnet, dass** das schalldämpfende Material wie an sich bekannt ein offen- oder geschlossenzelliger Stoff, vorzugsweise ein Polyurethan-Elastomer, Kautschuk- , Silikon-, EVA- oder PE-Schaum ist.

8. Antriebseinheit nach einem der Ansprüche 1 bis 7, **dadurch gekennzeichnet, dass** am zweiten Teil (6) des Gehäuses eine durch einen Klemmhebel (15) bedienbare Spannzange (14) und am ersten Teil (5) des Gehäuses eine Nase (12) angeordnet ist, wobei die Antriebseinheit (1) über die Nase (12) und die Spannzange (14) an einem Trägerelement (8) befestigbar ist.

9. Möbel mit einem Möbelkorpus und insbesondere einem am Möbelkorpus befestigten Trägerelement, **gekennzeichnet durch** eine am Möbelkorpus (2) bzw. gegebenenfalls am Trägerelement (8) befestigte Antriebseinheit (1) nach einem der Ansprüche 1 bis 8.

10. Möbel nach Anspruch 9, **dadurch gekennzeichnet, dass** der erste Teil (5) des Gehäuses der Antriebseinheit (1) den Möbelkorpus (2) bzw. gegebenenfalls das Trägerelement (8) nur über Bereiche (4) aus schalldämpfendem Material berührt.

11. Möbel nach Anspruch 9 oder 10, **dadurch gekennzeichnet, dass** die Schnittstelle (16) elektrische Leitungen (9), welche am Möbelkorpus (2) bzw. gegebenenfalls am Trägerelement (8) angeordnet sind, im Wesentlichen spielfrei kontaktiert.

## Claims

1. A drive unit (1) for a furniture article portion (13) which is mounted movably in or on a furniture body (2) comprising a housing in or on which are arranged an electric motor and an interface (16) for contacting electrical lines, wherein the electric motor is arranged in a first part (5) of the housing, wherein the interface (16) is arranged in or at a second part (6) of the housing which is limitedly movably supported with respect to the first part (5) of the housing, **characterised in that** the second part (6) of the housing is connected to the first part (5) of the housing, preferably exclusively, by a swivel joint.

2. A drive unit according to claim 1, **characterised in that** as is known per se arranged in or on the swivel joint are electrical lines which lead from the interface (16) at least to the electric motor.

3. A drive unit according to one of claims 1 to 2, **characterised in that** the interface (16) has piercing pins (17) of electrically conductive material.

4. A drive unit according to one of claims 1 to 3, **characterised in that** as is known per se an ejection lever (11) drivable by the electric motor is arranged on the first part (5) of the housing.

5. A drive unit according to one of claims 1 to 4, **characterised in that** all components of the drive unit (1), which generate noise in operation of the drive unit (1), are arranged exclusively in the first part (5) of the housing.

6. A drive unit according to one of claims 1 to 5, **characterised in that** as is known per se at least one region (3) of sound-damping material is arranged between the first and second parts (5, 6) of the housing.

7. A drive unit according to claim 6, **characterised in that** as is known per se the sound-damping material used is an open-cell or closed-cell material, preferably a polyurethane elastomer, a rubber, silicone, EVA or PE foam.

8. A drive unit according to one of claims 1 to 7, **characterised in that** arranged on the second part (6) of the housing is a clamping gripper (14) operable by a clamping lever (15) and arranged on the first part (5) of the housing is a nose (12), wherein the drive unit (1) can be fixed to the carrier element (8) by way of the nose (12) and the clamping gripper (14).

9. An article of furniture comprising a furniture body and in particular a carrier element fixed to the furniture body, **characterised by** a drive unit (1) according to one of claims 1 to 8, the drive unit (1) being fixed to the furniture body (2) or, where applicable, to the carrier element (8).

10. An article of furniture according to claim 9, **characterised in that** the first part (5) of the housing of the drive unit (1) is in contact with the furniture body (2) or, where applicable, with the carrier element (8) only by way of regions (4) of sound-damping material.

11. An article of furniture according to claim 9 or claim 10, **characterised in that** the interface (16) contacts in substantially play-free relationship electrical lines (9) arranged on the furniture body (2) or, where applicable, on the carrier element (8).

## Revendications

1. Unité d'entraînement (1) pour une partie de meuble (13) montée de manière à pouvoir être déplacée dans ou au niveau d'un corps de meuble (2), comportant un boîtier, dans lequel ou sur lequel sont disposés un moteur électrique et une interface (16) servant à établir un contact avec des lignes électriques, dans laquelle le moteur électrique est disposé dans une première partie (5) du boîtier, dans laquelle l'interface (16) est disposée dans ou au niveau d'une deuxième partie (6) du boîtier, laquelle deuxième partie est montée de manière à pouvoir être déplacée de manière limitée par rapport à la première partie (5) du boîtier, **caractérisée en ce que** la deuxième partie (6) du boîtier est reliée à la première partie (5) du boîtier, de préférence exclusivement, par une articulation rotative.

2. Unité d'entraînement selon la revendication 1, **caractérisée en ce que** des lignes électriques sont disposées dans ou sur l'articulation rotative tel que connu en soi, lesquelles partent de l'interface (16) pour aboutir au moins au moteur électrique.

3. Unité d'entraînement selon l'une quelconque des revendications 1 à 2, **caractérisée en ce que** l'interface (16) présente des contacts piercing (17) en un matériau électroconducteur.

4. Unité d'entraînement selon l'une quelconque des revendications 1 à 3, **caractérisée en ce qu'**un levier d'éjection (11) pouvant être entraîné par le moteur électrique est disposé au niveau de la première partie (5) du boîtier tel que connu en soi.

5. Unité d'entraînement selon l'une quelconque des revendications 1 à 4, **caractérisée en ce que** tous les composants de l'unité d'entraînement (1) générant du bruit lors du fonctionnement de l'unité d'entraînement (1) sont disposés exclusivement dans la première partie (5) du boîtier.

6. Unité d'entraînement selon l'une quelconque des revendications 1 à 5, **caractérisée en ce qu'**au moins une zone (3) en un matériau atténuant le bruit est disposée entre la première et la deuxième partie (5, 6) du boîtier tel que connu en soi.

7. Unité d'entraînement selon la revendication 6, **caractérisée en ce que** le matériau atténuant le bruit tel que connu en soi est une matière à cellules fermées ou à cellules ouvertes, de préférence un élastomére polyuréthane, de la mousse à base de caoutchouc, de la mousse silicone, de la mousse EVA ou de la mousse de polyéthyléne.

8. Unité d'entraînement selon l'une quelconque des revendications 1 à 7, **caractérisée en ce qu'**une pince de serrage (14) pouvant être commandée par un levier de serrage (15) est disposée au niveau de la deuxième partie (6) du boîtier et un ergot (12) est disposé au niveau de la première partie (5) du boîtier, dans laquelle l'unité d'entraînement (1) peut être fixée par l'intermédiaire de l'ergot (12) et de la pince de serrage (14) à un élément porteur (8).

9. Meuble comportant un corps de meuble et en particulier un élément porteur fixé sur le corps de meuble, **caractérisé par** une unité d'entraînement (1) selon l'une quelconque des revendications 1 à 8, fixée au corps de meuble (2) ou le cas échéant à l'élément porteur (8).

10. Meuble selon la revendication 9, **caractérisé en ce que** la première partie (5) du boîtier de l'unité d'entraînement (1) touche le corps de meuble (2) ou le cas échéant l'élément porteur (8) seulement par l'intermédiaire des zones (4) en un matériau atténuant le bruit.

11. Meuble selon la revendication 9 ou 10, **caractérisé en ce que** l'interface (16) met en contact essentiellement sans jeu des lignes (9) électriques, qui sont disposées au niveau du corps de meuble (2) ou le cas échéant au niveau de l'élément porteur (8).
